# EUROPEAN PATENT APPLICATION

(11) **EP 4 739 038 A1**
(43) Date of publication of application: **06.05.2026**
(21) Application number: 24847521.2
(22) Date of filing: 31.01.2024
(51) Int. Cl.: H10F 39/90

(54) **SOLAR CELL UNIT AND MANUFACTURING METHOD THEREFOR**

(30) Priority: 28.07.2023 CN 202310942977
(71) Applicant: Ja Solar Technology Yangzhou Co., Ltd., Yangzhou, Jiangsu 225131 (CN)
(72) Inventor: CHEN, Xiaoye, Yangzhou, Jiangsu 225131 (CN); ZHANG, Junbing, Yangzhou, Jiangsu 225131 (CN); JIANG, Xiulin, Yangzhou, Jiangsu 225131 (CN)
(74) Representative: Sun, Yiming
(86) International application number: PCT/CN2024/074890
(87) International publication number: WO 2025/025552

(57) **Abstract**

Embodiments of the present disclosure provide a solar cell unit and a manufacturing method therefor. The solar cell unit comprises: a silicon substrate which is an n-type silicon substrate; a passivation layer; a seed layer; an interfacial energy level adjustment layer which is a p-type hydrogenated doped silicon layer; and a first p-type conductive layer. The passivation layer, the seed layer, the interfacial energy level adjustment layer, and the first p-type conductive layer are successively stacked on a first side of the silicon substrate, and the passivation layer is closest to the silicon substrate. The interfacial energy level adjustment layer contains a silicon element, an oxygen element, a carbon element, a hydrogen element, and a boron element. The band gap of the interfacial energy level adjustment layer is 1.9-2.3 eV, and the thickness of the interfacial energy level adjustment layer is 0.5-4 nm.

## Description

The present application claims the priority of China Patent Application No. 202310942977.4 filed on July 28, 2023, titled with "SOLAR CELL AND MANUFACTURING METHOD THEREOF", and the disclosure of the above-mentioned China Patent Application is hereby incorporated in its entirety as a part of the present application.

### TECHNICAL FIELD

The embodiments of the present disclosure relate to a solar cell and a manufacturing method of a solar cell.

### BACKGROUND

Crystalline silicon-based heterojunction solar cell is a semiconductor device that can convert solar energy into electric power output. Generally, a heterojunction solar cell is manufactured by using an n-type silicon substrate, the heterojunction solar cell includes a silicon substrate, two passivation layers on both sides of the silicon substrate, and doped conductive layers on the passivation layers on both sides respectively. The manufacturing process of the silicon-based heterojunction solar cell is provided as follows: depositing hydrogenated amorphous silicon layers on both sides of the textured silicon substrate, respectively depositing a phosphorus-doped silicon layer and a boron-doped silicon layer on the surfaces of the hydrogenated amorphous silicon layers on both sides, depositing transparent conductive ITO (indium tin oxide) layers on the surfaces of the doped silicon layers, and finally forming electrodes on the ITO layers. The heterojunction solar cell has many advantages: high cell efficiency, no attenuation, few process steps and low energy consumption (the temperature is below 300 degrees). At present, the main factor limiting the large-scale market occupation of heterojunction solar cells is that the manufacturing cost is slightly higher than other photovoltaic cells. Therefore, it is still the development direction of heterojunction solar cell to continuously improve the photoelectric conversion efficiency and improve the cost performance of heterojunction solar cell.

### SUMMARY

At least one embodiment of the present disclosure provides a solar cell, which includes: a silicon substrate, which is an n-type silicon substrate; a passivation layer; a seed layer; an interface energy-level modification layer, which is a p-type hydrogenated doped silicon layer; and a first p-type conductive layer. The passivation layer, the seed layer, the interface energy-level modification layer, and the first p-type conductive layer are sequentially stacked in at least a part of an area of a first surface on a first side of the silicon substrate, and the passivation layer is closest to the silicon substrate, the interface energy-level modification layer includes silicon, oxygen, carbon, hydrogen and boron.

For example, in some embodiments, a thickness of the interface energy-level modification layer is in a range of 0.5 to 4 nm.

For example, in some embodiments, the thickness of the interface energy-level modification layer is in a range of 0. 7 to 1.8 nm.

For example, in some embodiments, a bandgap width of the interface energy-level modification layer is in a range of 1.9 to 2.3 eV.

For example, in some embodiments, the interface energy-level modification layer is a hydrogenated amorphous silicon layer and is embedded with crystallized silicon, and a crystallization rate of the interface energy-level modification layer is in a range of 30 to 65%.

For example, in some embodiments, the interface energy-level modification layer includes Si-Si, Si-O, Si-C, Si-B, C-C, C-O, C=O, C-B and B-O chemical bonds.

For example, in some embodiments, a total molar content of the carbon and the oxygen in the interface energy-level modification layer is in a range of 18 to 45%. A concentration of active boron atoms in the interface energy-level modification layer is in a range of 5×10¹⁷ to 5×10¹⁹ atoms per cubic centimeter.

For example, in some embodiments, a molar content of the carbon in the interface energy-level modification layer is in a range of 8-16%, and the carbon exists by forming Si-C, C-C, C-O, C=O, C-B and C-H chemical bonds. Molar ratios of carbon existing through Si-C, C-C, C-O, C=O, C-B and C-H chemical bonds to all carbon are 30-54%, 30-45%, 8-14%, 1-5%, 3-7% and 3-9%, respectively.

For example, in some embodiments, a molar content of the oxygen in the interface energy-level modification layer is in a range of 18-32%, and the oxygen exists by forming Si-O, C-O and B-O chemical bonds. Molar ratios of oxygens existing through Si-O, C-O and B-O chemical bonds to all oxygen are 78-92%, 6-15% and 4-11%, respectively.

For example, in some embodiments, a molar content of the silicon in the interface energy-level modification layer is in a range of 50-65%, and the silicon exists by forming Si-Si, Si-O, Si-C, Si-B and Si-H chemical bonds, a molar ratio of silicon existing through Si-Si, Si-B and Si-H chemical bonds to all silicon is 40-60%, a molar ratio of silicon existing through Si-O chemical bonds to all silicon is 35-45%, and a molar ratio of silicon existing through Si-C chemical bonds to all silicon is 7-12%.

For example, in some embodiments, a molar content of boron in the interface energy-level modification layer is in the range of 1-5%. Inactive boron atoms exist in the layer in form of B-O, B-C, B-B and B-H.

For example, in some embodiments, in the interface energy-level modification layer, in a direction away from the silicon substrate, a concentration of the active boron atoms increases and a crystallization rate of the interface energy-level modification layer increases.

For example, in some embodiments, the passivation layer is a hydrogenated amorphous silicon layer. In the passivation layer, a concentration of hydrogen atoms decreases in a direction away from the silicon substrate.

For example, in some embodiments, the first p-type conductive layer is a p-type microcrystalline silicon layer. A crystallization rate of the first p-type conductive layer is in a range of 30-70%. In the first p-type conductive layer, a crystallization rate increases in a direction away from the silicon substrate.

For example, in some embodiments, the passivation layer is a hydrogenated amorphous silicon layer, the first p-type conductive layer is a p-type microcrystalline silicon layer, a thickness of the passivation layer is in a range of 5-8 nm, a thickness of the seed layer is smaller than 1 nm, and a thickness of the first p-type conductive layer is in a range of 20-38nm.

For example, in some embodiments, the solar cell further includes a second p-type conductive layer, arranged on the first p-type conductive layer and further away from the silicon substrate than the first p-type conductive layer.

For example, in some embodiments, the second p-type conductive layer is a boron-doped amorphous silicon layer. A concentration of active boron atoms in the second p-type conductive layer is in a range of 2×10¹⁸-1×10¹⁹ atoms per cubic centimeter. A thickness of the second p-type conductive layer is in a range of 0.5-3 nm.

For example, in some embodiments, the first side is a backlight side of the solar cell.

For example, in some embodiments, the solar cell further includes: a second passivation layer and an n-type conductive layer. The second passivation layer and the n-type conductive layer are sequentially stacked on a second surface on a second side of the silicon substrate, the second side is opposite to the first side, and the second passivation layer is closest to the silicon substrate.

For example, in some embodiments, the solar cell further includes: a second passivation layer and an n-type conductive layer. The passivation layer, the seed layer, the interface energy-level modification layer, the first p-type conductive layer and the second p-type conductive layer are sequentially stacked in a p area on the first surface on the first side of the silicon substrate. The second passivation layer and the n-type conductive layer are sequentially stacked in an n area different from the p area on the first surface of the silicon substrate.

The present disclosure further provides a manufacturing method of a solar cell, which includes: providing a silicon substrate, the silicon substrate being a n-type silicon substrate; and sequentially stacking a passivation layer, a seed layer, an interface energy-level modification layer and a first p-type conductive layer in at least a part of an area of the first surface on the first side of the silicon substrate. The interface energy-level modification layer is a p-type hydrogenated doped silicon layer, and includes silicon, oxygen, carbon, hydrogen and boron.

For example, in some embodiments, a thickness of the interface energy-level modification layer is in a range of 0.5 to 4 nm.

For example, in some embodiments, the thickness of the interface energy-level modification layer is in a range of 0. 7 to 1.8 nm.

For example, in some embodiments, a bandgap width of the interface energy-level modification layer is in a range of 1.9 to 2.3 eV.

For example, in some embodiments, the interface energy-level modification layer is a hydrogenated amorphous silicon layer and is embedded with crystallized silicon, and a crystallization rate of the interface energy-level modification layer is in a range of 30 to 65%.

For example, in some embodiments, the interface energy-level modification layer is formed by using a reaction gas under the conditions that a pressure of reaction cavity is in a range of 2.5-3.5Torr and a radio frequency power density is in a range of 260-340 mW/cm². The silicon of the interface energy-level modification layer comes from one or more selected from the group consisting of SiH₄ and Si2H₆, the boron of the interface energy-level modification layer comes from one or more selected from the group consisting of TMB, B₂H₆ and BF₃, the hydrogen of the interface energy-level modification layer comes from one or more selected from the group consisting of H₂, SiH₄, B₂H₆ and TMB, the oxygen of the interface energy-level modification layer comes from one or more selected from the group consisting of N₂O, O₂, CO and CO₂, and the carbon of the interface energy-level modification layer comes from one or more selected from the group consisting of CO₂, CO, CH₄, C₂H₆, C₃H₁₀ and C₂H₄.

For example, in some embodiments, the manufacturing method further includes: sequentially stacking a second passivation layer and an n-type conductive layer on a surface on a second side of the silicon substrate, the second side is opposite to the first side.

For example, in some embodiments, the passivation layer, the seed layer, the interface energy-level modification layer, and the first p-type conductive layer are sequentially stacked in a p region on the first surface of the silicon substrate. The method further includes: sequentially staking a second passivation layer and a n-type conductive layer in a n region different from the p region on the first surface of the silicon substrate.

For example, in some embodiments, the method further includes: disposing a second p-type conductive layer on the first p-type conductive layer, and the second p-type conductive layer is further away from the silicon substrate than the first p-type conductive layer.

For example, in some embodiments, the second p-type conductive layer is a boron-doped amorphous silicon layer, wherein a concentration of active boron atoms in the second p-type conductive layer is in a range of 2×10¹⁸-1×10¹⁹ atoms per cubic centimeter. A thickness of the second p-type conductive layer is in a range of 0.5-3 nm.

### BRIEF DESCRIPTION OF DRAWINGS

Fig. 1 shows a schematic sectional view of a solar cell according to an embodiment of the present disclosure;
Fig. 2 shows an influence of using gases with different oxygen-silicon ratios and gases with different carbon-silicon ratios when forming an interface energy-level modification layer on a content of active boron atoms in the interface energy-level modification layer according to an embodiment of the present disclosure;
Fig. 3 shows an analysis result of boron in an interface energy-level modification layer formed by using hydrogen, silane, methane and trimethyl boron by using X-ray photoelectron spectroscopy according to an embodiment of the present disclosure;
Fig. 4 shows an analysis result of boron in an interface energy-level modification layer formed by using hydrogen, silane, oxygen and trimethyl boron by using X-ray photoelectron spectroscopy according to an embodiment of the present disclosure;
Figs. 5- 8 respectively show the analysis results of silicon, carbon, oxygen and boron in the interface energy-level modification layer formed by using hydrogen, silane, carbon monoxide and trimethyl boron by X-ray photoelectron spectroscopy according to the embodiment of the present disclosure, and Fig. 9 shows the Raman test spectrum of the interface energy-level modification layer;
Fig. 10 illustrates an influence of providing an interface energy-level modification layer on the performance of a solar cell according to an embodiment of the present disclosure;
Fig. 11 shows a schematic sectional view of a solar cell according to another embodiment of the present disclosure;
Fig. 12 illustrates an influence of interface energy-level modification layers with different thicknesses on the performance of the solar cell according to an embodiment of the present disclosure; and
Fig. 13 illustrates an influence of providing a second p-type conductive layer on the performance of a solar cell according to an embodiment of the present disclosure.

### DETAILED DESCRIPTION

Hereinafter, the solar cell and the manufacturing method thereof according to the embodiments of the present disclosure will be described in detail with reference to the drawings.

At least one embodiment of the present disclosure provides a solar cell and a manufacturing method thereof. By providing an interface energy-level modification layer between a passivation layer and a p-type conductive layer, the energy-level structure of the interface between a silicon substrate and other stacked semiconductor layers is optimized, so that the energy-level bending degree at the interface is strengthened, and the ability of the interface to separate, collect and conduct carriers is further enhanced. The electrical properties such as the filling factor of the heterojunction solar cell are improved, and the photoelectric conversion efficiency of the device is improved.

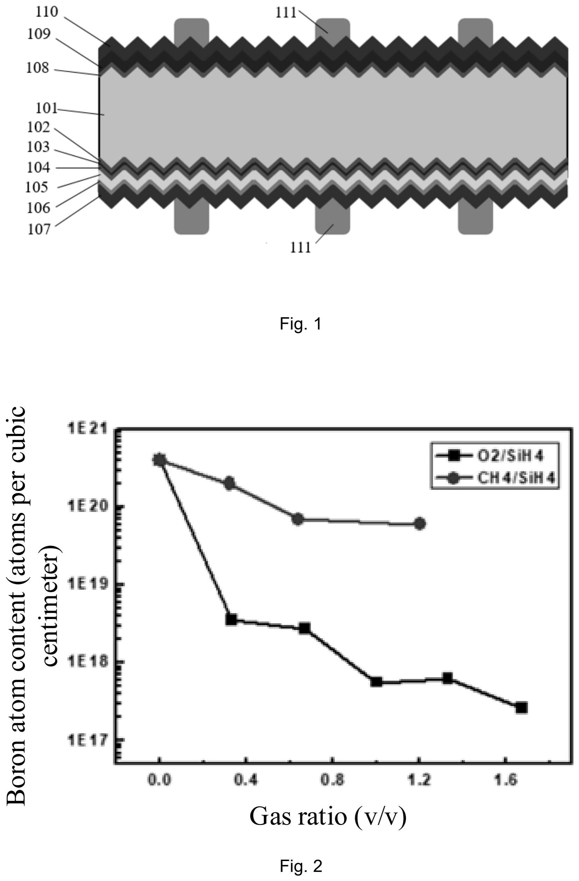

Fig. 1 shows a schematic sectional view of a solar cell according to an embodiment of the present disclosure. The solar cell is a silicon-based heterojunction solar cell. As illustrated by Fig. 1, the solar cell includes an n-silicon substrate 101, a passivation layer 102, a seed layer 103, an interface energy-level modification layer 104, a first p-type conductive layer 105, a second p-type conductive layer 106, an ITO conductive layer, a second passivation layer 108, a n-type conductive layer 109 and a second ITO conductive layer 100, the passivation layer 102, the seed layer 103, the interface energy-level modification layer 104, the first p-type conductive layer 105, the second p-type conductive layer 106 and the ITO conductive layer being sequentially disposed on a surface on a first side of the silicon substrate 101 in a direction away from the silicon substrate 101, the second passivation layer 108, the n-type conductive layer 109 and the second ITO conductive layer 100 being sequentially disposed on a surface on a second side of the silicon substrate 101 in a direction away from the silicon substrate 101, and the second side being opposite to the first side. In addition, the solar cell further includes electrodes 111 disposed on the ITO conductive layer 107 and the second ITO conductive layer 110.

For example, the first side is a backlight side of the solar cell, and the second side is a light-facing side. The passivation layer 102 may be a hydrogenated amorphous silicon layer. The thickness of the passivation layer 102 is in the range of 5-8 nm. In the passivation layer 102, the concentration of hydrogen atoms decreases in a direction away from the silicon substrate 101. Therefore, in the passivation layer, the passivation performance is better near the silicon substrate 101, while the part farther away from the silicon substrate 101 shows increased orderliness and better conductivity. The first p-type conductive layer 105 is a p-type microcrystalline silicon layer. The crystallization rate of the first p-type conductive layer 105 is in the range of 30-70 %. In the first p-type conductive layer 105, the crystallization rate increases in the direction away from the silicon substrate 101. Moreover, in the first p-type conductive layer 105, the doping concentration of active boron atoms increases in the direction away from the silicon substrate 101. For example, from 5×10¹⁷ atoms per cubic centimeter to 2×10²¹ atoms per cubic centimeter. For example, from 1×10¹⁸ atoms per cubic centimeter to 5×10²⁰ atoms per cubic centimeter. For example, from 1×10¹⁹ atoms per cubic centimeter to 2×10²⁰ atoms per cubic centimeter.

The silicon-based heterojunction solar cell uses intrinsic hydrogenated amorphous silicon layer to passivate the surface of silicon substrate 101, and different doped conductive silicon layers with different doping types are deposited on the surfaces of intrinsic hydrogenated amorphous silicon layer. In this way, the inner intrinsic hydrogenated amorphous silicon layer completes the passivation of the surface of the silicon substrate 101, and the outer doped conductive silicon layer bends the energy band of the interface between the silicon substrate 101 and the stacked semiconductor layers disposed on it by its own doping, thus completing the extraction and transmission of corresponding carriers. Therefore, the properties and matching conditions of each layer are particularly important for heterojunction solar cell. Because the chemical composition and microstructure of materials are quite different, various silicon layers have different properties. For example, crystalline silicon is an indirect bandgap material with a bandgap width of 1.12eV, for example. Intrinsic amorphous silicon layer is a material similar to direct bandgap material, and its bandgap width is, for example, 1.6-1.7eV. The bandgap width of intrinsic microcrystalline silicon layer is between amorphous silicon and crystalline silicon, which changes with the change of crystallization rate of the layer. Doping the microcrystalline silicon can change the bandgap width of the layer. Generally speaking, the bandgap width of phosphorus-doped microcrystalline silicon layer is between 1.2 and 1.7 eV, and the bandgap of boron-doped microcrystalline silicon layer is between 1.2 and 1.6 eV. The rule is that the bandgap width of microcrystalline silicon layer decreases with the increase of the corresponding active boron atom doping concentration or active phosphorus atom doping concentration. Oxidation and carbonization of boron-doped or phosphorus-doped hydrogenated microcrystalline silicon layer can increase the bandgap of the layer, for example, the bandgap of boron-doped hydrogenated microcrystalline silicon layer can be adjusted from 1.2eV to 2.3eV.

When manufacturing a p-n junction on the surface of heterojunction solar cell, an intrinsic amorphous silicon layer as a passivation layer 102 is deposited on a surface of n-type textured silicon substrate 101 to passivate the silicon substrate 101, and then a doped hydrogenated silicon layer is deposited on the surface of passivation layer 102. The doped hydrogenated silicon layer can be a doped hydrogenated amorphous silicon layer or a doped hydrogenated microcrystalline silicon layer. Because some silicon atoms in the microcrystalline silicon layer are crystallized, the doping concentration of active boron atoms is increased, and thus the conductivity of the layer is improved. When the deposition of the doped hydrogenated silicon layer is completed on the surface of the silicon substrate 101 to obtain a p-n junction, an energy-level structure of the interface between the silicon substrate 101 and other stacked semiconductor layers is also formed at the same time. The Fermi level of the interface tends to level off after the movement of carriers such as migration and compensation. The bandgap width of each layer is fixed, and if the energy-level structure of the interface cannot be well matched, a potential barrier will be formed at the interface, which is not facilitate to the separation and conduction of carriers. For the p-n junction of heterojunction solar cell, due to the existence of doped silicon layer, a space charge area will be formed in a certain area on the surface of n-type silicon substrate 101, which is characterized by the upward bending of the energy-level structure in the silicon substrate 101 in this area, that is, the conduction band and valence band of the surface of silicon substrate 101 in contact with passivation layer 102 are simultaneously bent upward. In this interface electron energy-level structure, the upward bending of valence band of the surface of silicon substrate 101 is very important for the separation, collection and conduction of carrier holes. Enhancing the upward bending degree of valence band of the silicon substrate 101 side of the interface is an effective way to further improve the filling factor of heterojunction solar cell and the key to further improve the conversion efficiency of heterojunction solar cell.

In the embodiment of the present disclosure, the interface energy-level modification layer 104 is disposed between the passivation layer 102 and the p-type conductive layer, which can improve the electron energy-level structure of the interface, thereby improving the battery filling factor.

In an embodiment, the interface energy-level modification layer 104 is a boron-doped hydrogenated microcrystalline silicon layer containing carbon and oxygen. For example, the bandgap width of the interface energy-level modification layer 104 is between 1.9 and 2.3 eV.

On the one hand, because the interface energy-level modification layer 104 has a relatively wide bandgap width, when the interface energy-level modification layer 104 is disposed between the intrinsic amorphous silicon layer as the passivation layer 102 and the p-type microcrystalline silicon layer as the p-type conductive layer, the upward bending degree of the energy-level of the interface at the silicon substrate 101 side will be increased due to the energy-level re-matching. Specifically, the valence band energy-level of the surface of the silicon substrate 101 is further bent upward at the interface where the silicon substrate 101 contacts with the passivation layer 102, which is beneficial to the movement and accumulation of holes in the silicon substrate 101 towards the interface, increasing the probability of unidirectional extraction and conduction of holes by the stacked semiconductor layers disposed on the silicon substrate 101, and improving the filling factor of the heterojunction solar cell.

On the other hand, because the interface energy-level modification layer 104 has a relatively wide bandgap, at the stacked semiconductor layers side, the conduction band in the intrinsic amorphous silicon layer as the passivation layer 102 and the interface energy-level modification layer 104 is enabled to be further bent upward. In this way, the interface can repel electrons in the silicon substrate 101, and at the same time, the ability of injecting electrons in the stacked semiconductor layers into the silicon substrate 101 is enhanced, thus reducing the recombination probability of carriers at the interface.

In an embodiment, the interface energy-level modification layer 104 contains oxygen and carbon, and contains Si-O chemical bonds and Si-C chemical bonds. For example, the interface energy-level modification layer 104 includes silicon, oxygen, carbon, hydrogen and boron, so that Si-Si, Si-O, Si-C, Si-B, C-C, C-O, C=O, C-B and B-O chemical bonds act as the layer network formers, and dangling bonds in the layer is passivated and saturated by forming Si-H, C-H, and B-H chemical bonds as the network modifiers with hydrogen.

The interface energy-level modification layer 104 contains oxygen, and the oxygen in the reaction gas will react with boron during the film deposition to generate boron oxide, thus reducing the concentration of active boron atoms in the film layer. In this way, the activation energy of the layer increases due to the reduction of the content of active boron atoms, resulting in poor conductivity of the layer. However, if the oxygen content in the layer is directly reduced, the bandgap of the layer will be reduced, and the energy-level adjustment function will not be achieved. By increasing the carbon content in the layer, the present disclosure can reduce the oxygen content in the layer while controlling the total carbon and oxygen content, so as to maintain the layer with a higher bandgap width to solve such a contradiction. At the same time, reducing the oxygen content in the layer can increase the content of active boron atoms in the layer, so that the interface energy-level modification layer 104 has both good conduction ability and excellent energy-level modification ability.

By adjusting the thickness of the interface energy-level modification layer 104, the energy-level modification ability of the interface energy-level modification layer 104 can be optimized. In some embodiments, the thickness of the interface energy-level modification layer 104 is in the range of 0.5 to 4 nm, or in the range of 0.7 to 1.8 nm.

In addition, the refractive index of the interface energy-level modification layer 104 may be in the range of 2.0-2.4. The interface energy-level modification layer 104 is a hydrogenated amorphous silicon layer in which crystallized silicon (or a hydrogenated microcrystalline silicon oxide layer) is embedded. The crystallization rate of the interface energy-level modification layer 104 is in the range of 30 to 65%. In the direction away from the silicon substrate 101, the concentration of active boron atoms increases, and the crystallization rate of the interface energy-level modification layer 104 increases. For example, the molar content of boron in the interface energy-level modification layer 104 is in the range of 1-5%. For example, the concentration of active boron atoms in the interface energy-level modification layer 104 is in the range of 5×10¹⁷-5×10¹⁹ atoms per cubic centimeter, and the rest inactive boron atoms exist in the layer in the form of B-O, B-C, B-B and B-H.

The molar content of the silicon in the interface energy-level modification layer 104 may be in the range of 50-65%, and the silicon exists by forming Si-Si, Si-O, Si-C, Si-B and Si-H chemical bonds. For example, a molar ratio of silicon existing through Si-Si, Si-B and Si-H chemical bonds to all silicon is in the range of 40-60%, a molar ratio of silicon existing through Si-O chemical bonds to all silicon is in the range of 35-45%, and a molar ratio of silicon existing through Si-C chemical bonds to all silicon is in the range of 7-12%.

The molar content of the carbon in the interface energy-level modification layer 104 can be in the range of 8-16%, and carbon exists by forming Si-C, C-C, C-O, C=O, C-B and C-H chemical bonds. For example, the molar ratios of carbon existing through Si-C, C-C, CO, C=O, C-B and C-H chemical bonds to all carbon are 30-54%, 30-45%, 8-14%, 1-5%, 3-7% and 3-9%, respectively.

The molar content of the oxygen in the interface energy-level modification layer 104 can be in the range of 18-32%, and oxygen exists by forming Si-O, C-O and B-O chemical bonds. For example, a molar ratio of oxygen existing through Si-O, C-O and B-O chemical bonds to all oxygen are 78-92%, 6-15% and 4-11% respectively.

The seed layer 103 provides conditions for the uniform growth of the interface energy-level modification layer 104. For example, the thickness of the seed layer 103 is less than 1 nm. The seed layer may include hydrogenated amorphous silicon and hydrogenated microcrystalline silicon, for example, and may include a small amount of hydrogenated amorphous silicon and a large amount of hydrogenated microcrystalline silicon.

The first p-type conductive layer 105 is a p-type microcrystalline silicon layer, and the crystallization rate of the first p-type conductive layer 105 is in the range of 30-70 %. And in the first p-type conductive layer 105, the crystallization rate increases in the direction away from the silicon substrate 101. The thickness of the first p-type conductive layer 105 may be in the range of 20-38 nm. But the present disclosure is not limited thereto.

The second p-type conductive layer 106 is a boron heavily doped amorphous silicon layer. For example, in the second p-type conductive layer, the concentration of active boron atoms is in the range of 2×10¹⁸-1×10¹⁹ atoms per cubic centimeter. The thickness of the second p-type conductive layer 106 may be in the range of 0.5-3nm. But the present disclosure is not limited thereto.

The n-type conductive layer can be a phosphorus-doped microcrystalline silicon layer and has a thickness of 12-18nm.

In an embodiment according to the present disclosure, the thickness of the passivation layer is in the range of 5-8 nm, the thickness of the seed layer is less than 1 nm, the thickness of the interface energy-level modification layer is in the range of 0.5 to 4 nm, and the thickness of the first p-type conductive layer is in the range of 20 to 38 nm. Preferably, the thickness of the interface energy-level modification layer is in the range of 0.7 to 1.8 nm. Due to the existence of the interface energy-level modification layer with appropriate thickness, the upward bending degree of valence band energy-level at the side of the silicon substrate and downward bending of conduction band at the side of the stacked semiconductor layer are significantly improved at the interface of the silicon substrate, thus improving the performance of the solar cell. By setting the seed layer with a thickness less than 1 nm, the crystallization rate and crystallization uniformity of the interface energy-level modification layer are improved. In addition, the first p-type conductive layer is an important part of the formation of the p-n junction of heterojunction solar cells. By setting the first p-type conductive layer to a certain thickness to form a more suitable p-n junction structure, carriers are ensured to be selectively separated and conducted under the action of the built-in electric field at the interface p-n junction, thus ensuring the performance of the solar cell, and at the same time avoiding energy consumption and waste of raw materials caused by the excessively thick first p-type conductive layer.

Preferably, the concentration of boron atoms in the first p-type conductive layer is gradually increased from the silicon substrate to the outside by gradient setting, and the valence band of the layer is further bent upward due to the gradual change of doping concentration in the first p-type conductive layer, thereby enhancing the unidirectional conduction and transmission ability of holes in the layer and further improving the performance of the solar cell.

In addition, preferably, the first p-type conductive layer is also provided with a second p-type conductive layer with a thickness in the range of 0.5-3 nm. The second p-type conductive layer can further improve the performance of the solar cell (described in detail below).

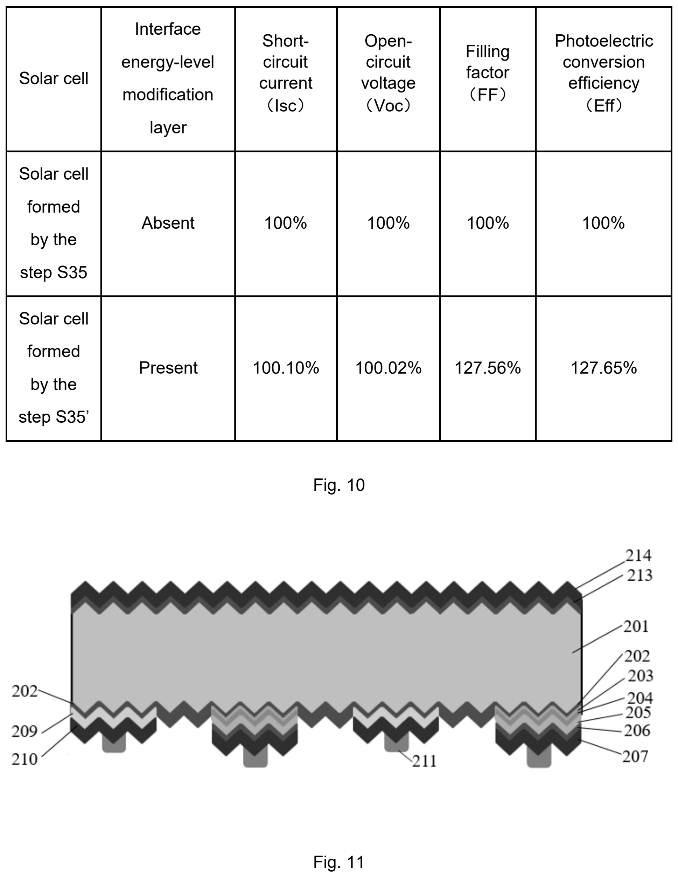

Fig. 11 shows a schematic sectional view of a solar cell according to another embodiment of the present disclosure. The solar cell is a silicon-based heterojunction solar cell. As illustrated by Fig. 11, the solar cell includes an n-silicon substrate 201, a passivation layer 202, a seed layer 203, an interface energy-level modification layer 204, a first p-type conductive layer 205, a second p-type conductive layer 206, an ITO conductive layer 207, a passivation layer 202, an n-type conductive layer 209, a second ITO conductive layer 210, a silicon oxide layer 213 and a silicon nitride layer 214. The passivation layer 202, the seed layer 203, the interface energy-level modification layer 204, the first p-type conductive layer 205, the second p-type conductive layer 206 and the ITO conductive layer 207 are sequentially disposed in a direction away from the silicon substrate 201 in a p area on a surface on a first side of the silicon substrate 201. The passivation layer 202, the n-type conductive layer 209 and the second ITO conductive layer 210 are sequentially disposed in a direction away from the silicon substrate 201 in an n area on the surface on the first side of the silicon substrate 201. The silicon oxide layer 213 and the silicon nitride layer 214 are sequentially disposed on a surface on a second side of the silicon substrate 201. For example, the first side is the backlight side and the second side is the light-facing side. In addition, the solar cell further includes electrodes 211 disposed on the ITO conductive layer 207 and the second ITO conductive layer 210. The properties of each layer of the solar cell can be the same as or similar to those of the corresponding layers mentioned above.

At least one embodiment of the present disclosure also provides a manufacturing method of a solar cell, which can be used for manufacturing the solar cell as described above, for example. The method may include the following steps: step S11, providing n-type silicon substrates 101 and 201; and step S12, sequentially stacking passivation layers 102, 202, seed layers 103, 203, interface energy-level modification layers 104, 204, first p-type conductive layers 105, 205 and second p-type conductive layers 106, 206 on the first side of the silicon substrates 101, 201.

In an embodiment, the method is used for manufacturing the solar cell as described above, the passivation layers 102, 202, the seed layers 103, 203, the interface energy-level modification layers 104, 204, the first p-type conductive layers 105, 205 and the second p-type conductive layers 106, 206 can be formed by plasma enhanced chemical vapor deposition (PECVD). For example, a radio frequency power supply (RF) or a very high frequency power supply (VHF) can be used as a plasma excitation source, and the film deposition pressure is in the range of 0.4-5Torr, and the film deposition temperature is in the range of 140-220 degrees.

In step S12, the interface energy-level modification layers 104 and 204 with a thickness in the range of 0.7 to 4 nm are formed by using the reaction gas under the conditions that the pressure of the reaction chamber is in the range of 2.5-3.5 Torr and the radio frequency power density is in the range of 260-340 mW/cm². For example, the silicon in the interface energy-level modification layers 104 and 204 is from one or more selected from a group consisting of SiH₄ and Si2H₆, the boron in the interface energy-level modification layers 104 and 204 is from one or more selected from a group consisting of TMB (trimethyl boron), B₂H₆ and BF₃, the hydrogens in the interface energy-level modification layers 104 and 204 is from one or more selected from a group consisting of H₂, SiH₄, Si2H₆ and TMB, and the oxygen in the interface energy-level modification layers 104 and 204 is from one or more selected from a group consisting of N₂O, O₂, CO, and CO₂, and the carbon in the interface energy-level modification layers 104 and 204 is from one or more selected from the group consisting of CO₂, CO, CH₄, C₂H₆, C₃H₁₀, and C₂H₄.

In step S12, using silane as the deposition gas and a 13.56MHz RF power source as a plasma excitation source, the passivation layer 102, 202 with a thickness of 5-8nm is formed under the condition that the RF power density is in a range of 10-50 mW/cm².

In step S12, using hydrogen and silane as reaction gases and a 13.56MHz RF power supply as a plasma excitation source, the seed layer 103, 203 with a thickness less than 1 nm is formed under the conditions that the flow ratio of hydrogen and silane is greater than 300 and the RF power density is in a range of 100-150 mW/cm².

In step S12, using hydrogen, silane and diborane as reaction gases, and a 13.56MHz RF power supply as a plasma excitation source, the first p-type conductive layer with a thickness of 0-38nm is formed under the condition that the RF power density is in a range of 260-320 mW/cm².

In step S12, using silane and diborane as reaction gases and a 13.56MHz RF power supply as a plasma excitation source, the second p-type conductive layer with a thickness of 0.5-3nm is formed under the condition that a RF power density is in a range of 20-50 mW/cm².

The formed solar cell may be the solar cell described in connection with Fig. 1 or Fig. 11.

In an embodiment of the present disclosure, preparing an interface energy-level modification layer by different reaction gases and detecting the content of active boron atoms in the formed interface energy-level modification layer includes the following steps:
Step S21: providing an n-type monocrystalline silicon substrate with a bulk resistivity of 2.5Ω•cm.
Step S22: cleaning a surface of the silicon substrate.
Step S23: depositing an interface energy-level modification layer on the surface of the silicon substrate. A layer with a thickness of 30 nm is deposited on the surface of silicon substrate by a PECVD process. Hydrogen, silane, methane and trimethyl boron are used as reaction gases, and the flow ratio of the mixed gases is 500: 1: (0-1.2): 0.02. When the layer is deposited, the cavity pressure is 450 Pa and the RF power density is 320 mW/cm².

Instead of step S23, step S23' is performed to deposit an interface energy-level modification layer on the surface of the silicon substrate. A layer with a thickness of 30 nm is deposited on the surface of silicon substrate by a PECVD process. Different from step S23, hydrogen, silane, oxygen and trimethyl boron are used as reaction gases, and the flow ratio of the mixed gases is 500: 1: (0-1.7): 0.02. When the film is deposited, the cavity pressure is 450 Pa and the RF power density is 320 mW/cm².

Instead of step S23, step S23" is performed to deposit an interface energy-level modification layer on the surface of the silicon substrate. A layer with a thickness of 30 nm is deposited on the surface of silicon substrate by a PECVD process. Different from step S23, hydrogen, silane, carbon monoxide and trimethyl boron are used as reaction gases, and the flow ratio of the mixed gases is 500: 1: 2: 0.02. When the film is deposited, the cavity pressure is 450 Pa and the RF power density is 320 mW/cm².

Step S24: detecting concentration of active boron atoms in the interface energy-level modification layer formed in step S23, step S23' and step S23" respectively.

Fig. 2 shows an influence of using gases with different oxygen-silicon ratios and gases with different carbon-silicon ratios when forming the interface energy-level modification layer on the content of active boron atoms in an interface energy-level modification layer. Specifically, Fig. 2 shows the concentration of active boron atoms in the interface energy-level modification layer formed in steps S23 and S23'. As illustrated by Fig. 2, with the increase of oxygen content in the interface energy-level modification layer, the content of active boron atoms in the interface energy-level modification layer decreases sharply.

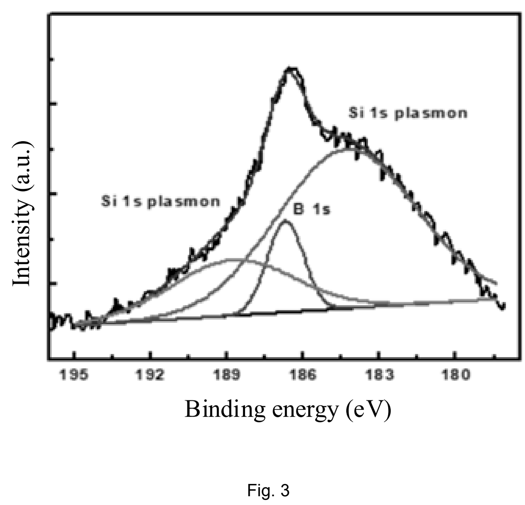

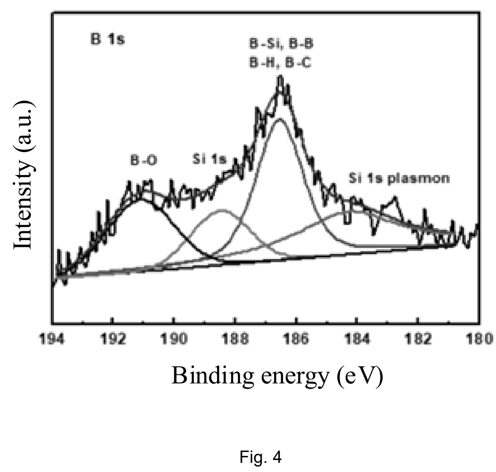

Fig. 3 shows an analysis result of boron in an interface energy-level modification layer formed by using hydrogen, silane, methane and trimethyl boron (in step S23) by using X-ray photoelectron spectroscopy, and Fig. 4 shows an analysis result of boron in the interface energy-level modification layer formed by using hydrogen, silane, oxygen and trimethyl boron (in step S23') by using X-ray photoelectron spectroscopy. As illustrated by Fig. 3, when the interface energy-level modification layer is formed using methane as the reaction gas, boron is not oxidized. As illustrated by Fig. 4, when the interface energy-level modification layer is formed by using oxygen as the reaction gas, part of boron atoms combine with oxygen to generate boron oxide compounds, thus reducing the concentration of active boron atoms in the interface energy-level modification layer, increasing the activation energy of the interface energy-level modification layer and weakening the electrical conductivity.

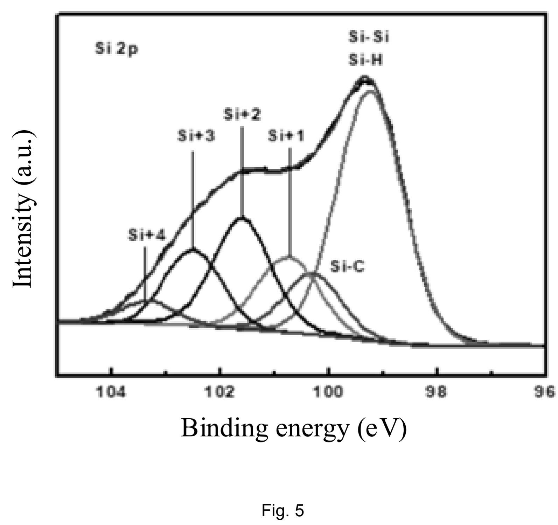

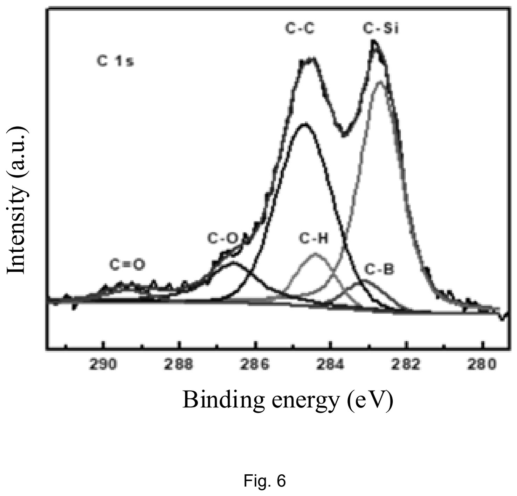

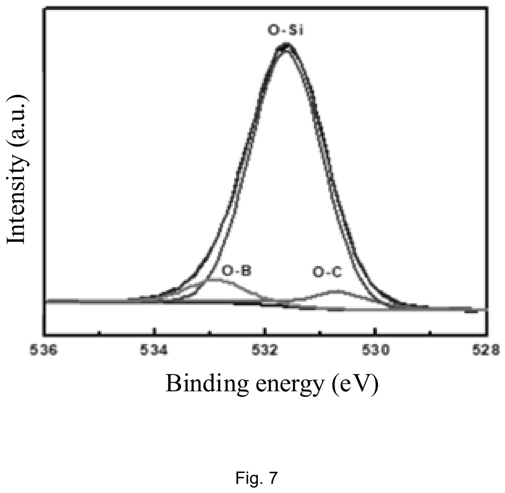

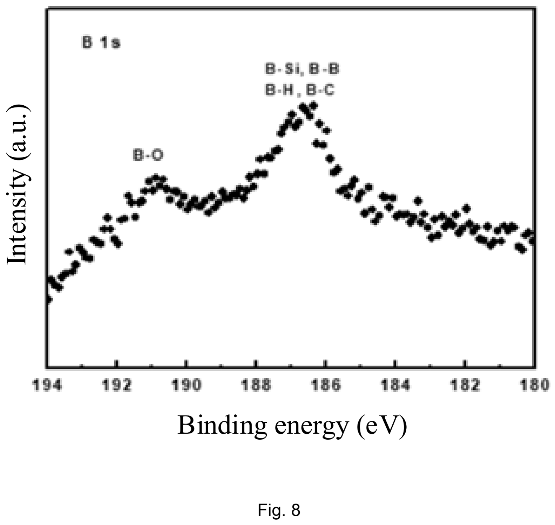

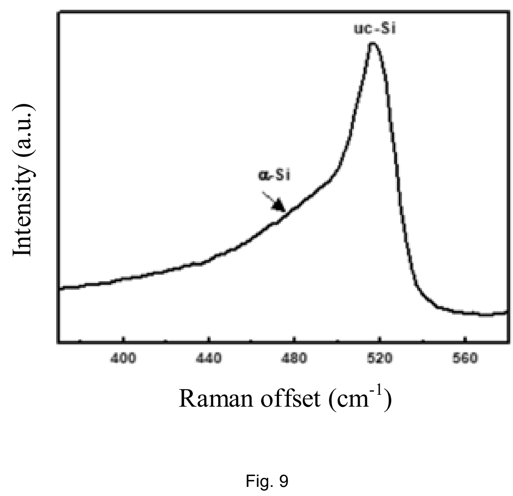

Figs. 5- 8 respectively show analysis results of silicon, carbon, oxygen and boron in the interface energy-level modification layer formed by using hydrogen, silane, carbon monoxide and trimethyl boron (in step S23"), and Fig. 9 shows the Raman test chart of the interface energy-level modification layer. As illustrated by Fig. 5 and Fig. 7, a large proportion of silicon atoms in the interface energy-level modification layer are combined with oxygen atoms. Because the number of oxygen atoms provided is not enough to make all silicon atoms oxidized, the results show that the chemical state of silicon atoms in silicon oxide in the interface energy-level modification layer is distributed from +1 valence to +4 valence; some silicon atoms combine with carbon to form Si-C chemical bonds. Due to the formation of Si-O and Si-C bonds, the bandgap width of the interface energy-level modification layer is broadened. As illustrated by Fig. 6, nearly half of the carbon atoms form Si-C bonds with silicon, and the carbon atoms enter the interface energy-level modification layer to widen its bandgap. As illustrated by Fig. 8, the total molar content of boron atoms in the interface energy-level modification layer reached 5%, and nearly 45% of boron atoms were oxidized, and another part of boron atoms entered the interface energy-level modification layer by forming chemical bonds of B-C, B-B, B-Si and B-H. As illustrated by Fig. 9, the crystallization rate of the silicon component of the interface energy-level modification layer is 48%.

In another embodiment (Embodiment 1) of the present disclosure, a solar cell is manufactured by the following steps:
Step S31: providing an n-type monocrystalline silicon substrate with a bulk resistivity of 2.5Ω•cm.
Step S32: performing a surface treatment on the silicon substrate, including texturing and cleaning. The silicon substrate can be anisotropically etched with 5% sodium hydroxide alkali solution, and the textured silicon substrate surface can be obtained, and its reflectivity is not more than 12%.

In step S33: respectively forming a passivation layer and a second passivation layer formed on the two surfaces at a first side and a second side of the silicon substrate. PECVD process can be used to form hydrogenated amorphous silicon layer on both surfaces of silicon substrate as the passivation layer and the second passivation layer. The thicknesses of the passivation layer and the second passivation layer may be 10 nm. The pseudo-open circuit voltage after double-sided passivation reaches 750mV.

Step S34: forming an n-type conductive layer on the second passivation layer at the second side. The PECVD process can be used to form a phosphorus-doped hydrogenated microcrystalline silicon carbide layer as an n-type conductive layer on the second passivation layer. The reaction gases used are SiH₄, H₂, CO₂ and PH₃, and the thickness of the n-type conductive layer is 15 nm.

Step S35: sequentially forming a seed layer, a first p-type conductive layer and a second p-type conductive layer on the passivation layer on the first side. The stacked layers can be formed by using PECVD processes.

Specifically, SiH₄ and H₂ are used as reaction gases, and the flow ratio of silane to hydrogen is 300, so that a seed layer with a thickness of 0.5 nm is formed. Furthermore, the seed layer is formed by using a 13.56MHz RF power supply as a plasma excitation source and with a RF power density of 120 mW/cm².

Using PECVD process, using the mixed gas of silane, hydrogen and trimethyl boron as the reaction precursor, a first p-type conductive layer with a thickness of 28 nm is formed on the seed layer, and the first p-type conductive layer is a boron-doped microcrystalline silicon layer. Furthermore, the first p-type conductive layer is formed using a 13.56MHz RF power source as a plasma excitation source and with a RF power density of 300 mW/cm².

Using a PECVD process and SiH₄ and B₂H₆ as reaction gases, a second p-type conductive layer with a thickness of 1.6 nm is formed, and the second p-type conductive layer is a boron-doped amorphous silicon layer. Using a 13.56MHz RF power supply as a plasma excitation source, the second p-type conductive layer is formed at a RF power density of 30 mW/cm².

Step S36: respectively forming ITO layers on the second p-type conductive layer and the n-type conductive layer. The two ITO transparent conductive layers can be formed by PVD equipment with a thickness of 80nm.

Step S37: forming electrodes, and the electrodes are respectively formed on two ITO layers by using low-temperature silver paste printing.

In another embodiment (Embodiment 2) of the present disclosure, a solar cell is manufactured through steps similar to steps S31-S37. Different from the manufacturing method including steps S31-S37, step S35 is replaced by step S35'. In step S35', a seed layer, an interface energy-level modification layer, a first p-type conductive layer and a second p-type conductive layer are sequentially formed on the passivation layer on the first side.

Specifically, the seed layer, the first p-type conductive layer and the second p-type conductive layer are formed in the same way as in step S35. In addition, an interface energy-level modification layer with a thickness of 2 nm is formed on the seed layer by PECVD process, using the mixed gas of silane, hydrogen, carbon monoxide and trimethyl boron as the reaction precursor.

The formed solar cell may be the solar cell described in connection with Fig. 1.

The performance of the solar cell formed by steps S31-S37 and the performance of the solar cell formed by steps S31-S34, S35' and S36-S37 are tested, and the results are shown in Fig. 10.

As illustrated by Fig. 10, when the short-circuit current, open-circuit voltage, filling factor and photoelectric conversion efficiency of the solar cell (Embodiment 1) formed by steps S31-S37 are set to 100%, the short-circuit current, open-circuit voltage, filling factor and photoelectric conversion efficiency of the solar cell (Embodiment 2) formed by steps S31-S34, S35' and S36-S37 are 100.1%, 100.02%, 127.56%, and 127.65% respectively. By setting the interface energy-level modification layer, the filling factor and photoelectric conversion efficiency of the solar cell can be greatly improved.

In another embodiment (Embodiment 3) of the present disclosure, a solar cell is manufactured by the following steps:
Step S41: providing an n-type monocrystalline silicon substrate with a bulk resistivity of 2.3Ω•cm.
Step S42: performing a surface treatment to the silicon substrate, the surface treatment includes texturing and cleaning. The silicon substrate can be anisotropically etched with 5% sodium hydroxide alkali solution, and the textured silicon substrate surface can be obtained, and its reflectivity is not more than 12%.
Step S43: forming stacked layers of a silicon oxide layer and a silicon nitride layer on the surface on a second side of the silicon substrate. The silicon oxide layer can be formed on the surface (e.g., front surface) on the second side of the silicon substrate using a thermal oxidation process, and then a silicon nitride layer with a thickness of 78 nm can be formed on the silicon oxide layer by using a PECVD process, and the refractive index of the stacked layers is 2.1.
Step S44: cleaning the surface on the first side of the silicon substrate. A 1% concentration hydrofluoric acid solution may be used to clean the surface (e.g., the back surface) on the first side of the silicon substrate.
Step S44: forming a passivation layer on the surface on the first side of the silicon substrate. A PECVD process can be used to form a hydrogenated amorphous silicon layer as a passivation layer on the surface on the first side of the silicon substrate, and the thickness of the hydrogenated amorphous silicon layer is 10 nm.
Step S45: sequentially forming a seed layer, an interface energy-level modification layer, a first p-type conductive layer and a second p-type conductive layer in a p region on the passivation layer. A mask can be used to cover the pre-designed p area and expose the n area; then, a phosphorus-doped hydrogenated microcrystalline silicon carbide layer is formed on the passivation layer by PECVD process as an n-type conductive layer. The reaction gases used are SiH₄, H₂, CO₂ and PH₃, and the thickness of the n-type conductive layer is 15 nm.
Step S46: sequentially forming a seed layer, an interface energy-level modification layer, a first p-type conductive layer and a second p-type conductive layer in the p area on the passivation layer. A mask can be used to cover the pre-designed n area and expose the p area. The stacked layers are then formed using PECVD processes. The seed layer, the interface energy-level modification layer, the first p-type conductive layer and the second p-type conductive layer may be formed by the same or similar method as in step S35'.
Step S47: forming a second ITO layer on the n-type conductive layer in the n area and an ITO layer on the second p-type conductive layer in the p area. Local ITO layers can be prepared by using a mask, and ITO transparent conductive layers with a thickness of 80 nm can be formed in corresponding areas by PVD process.
Step S48: forming electrodes, and electrodes are respectively formed on the ITO layer and the second ITO layer by using low-temperature silver paste printing.

The formed solar cell may be the solar cell described in connection with Fig. 11.

In another embodiment (Embodiment 4) of the present disclosure, a solar cell is manufactured by the following steps:
Step S51: providing an n-type monocrystalline silicon substrate with a bulk resistivity of 2.5Ω•cm.
Step S52: performing a surface treatment on the silicon substrate, the surface treatment includes texturing and cleaning. The silicon substrate can be anisotropically etched with 5% sodium hydroxide alkali solution, and the textured silicon substrate surface can be obtained, and its reflectivity is not more than 12%.
Step S53: respectively forming a passivation layer and a second passivation layer on the two surfaces on the first side and the second side of the silicon substrate. PECVD process can be used to form hydrogenated amorphous silicon layers as passivation layer and second passivation layer on both surfaces of silicon substrate. The thickness of the passivation layer and the second passivation layer may be 10 nm. The pseudo-open circuit voltage after double-sided passivation reaches 750 mV.
Step S54: forming an n-type conductive layer on the second passivation layer at the second side. PECVD process can be used to form a phosphorus-doped hydrogenated microcrystalline silicon carbide layer as an n-type conductive layer on the second passivation layer. The reaction gases used are SiH₄, H₂, CO₂ and PH₃, and the thickness of the n-type conductive layer is 15 nm.
Step S55: forming a seed layer and an interface energy-level modification layer on the passivation layer on the first side. SiH₄ and H₂ can be used as reaction gases, and the flow ratio of silane and hydrogen is 300, to form a seed layer with a thickness of 0.5 nm. In addition, a phosphorus-doped hydrogenated microcrystalline silicon carbide layer can be formed on the second passivation layer as an interface energy-level modification layer by PECVD process.

In different examples, PECVD process can be used to form boron-doped hydrogenated microcrystalline silicon carbide layers with different thicknesses on the passivation layer as the interface energy-level modification layer by using the mixed gas of SiH₄, H₂, CO₂ and B₂H₆ as the reaction precursors. In different examples, the thickness of the interface energy-level modification layer is 0.5 nm, 0.9 nm, 1.25 nm, 1.6 nm, 1.9 nm and 2.6 nm, respectively. The thickness can be controlled by adjusting the deposition time.

Step S56: forming a first p-type conductive layer on the interface energy-level modification layer on the first side. PECVD process can be used to form a boron-doped hydrogenated microcrystalline silicon layer with a thickness of 24 nm as the first p-type conductive layer on the interface energy-level modification layer by using mixed gas as the reaction precursor, and the first p-type conductive layer can be formed by using a 13.56MHz RF power supply as the plasma excitation source at a RF power density of 290 mW/cm².

Step S57: forming a second p-type conductive layer on the first p-type conductive layer on the first side. PECVD process can be used to form a second p-type conductive layer with a thickness of 1.6 nm by using SiH₄ and B₂H₆ as reaction gases, and the second p-type conductive layer is a boron-doped amorphous silicon layer. Using a 13.56MHz RF power supply as a plasma excitation source, the second p-type conductive layer was formed at a RF power density of 400 mW/cm².

Step S58: respectively forming ITO layers on the second p-type conductive layer and the n-type conductive layer. The two ITO transparent conductive layers can be formed by PVD equipment with a thickness of 80 nm.

Step S59: forming electrodes, and electrodes are respectively formed on two ITO layers by low-temperature silver paste printing.

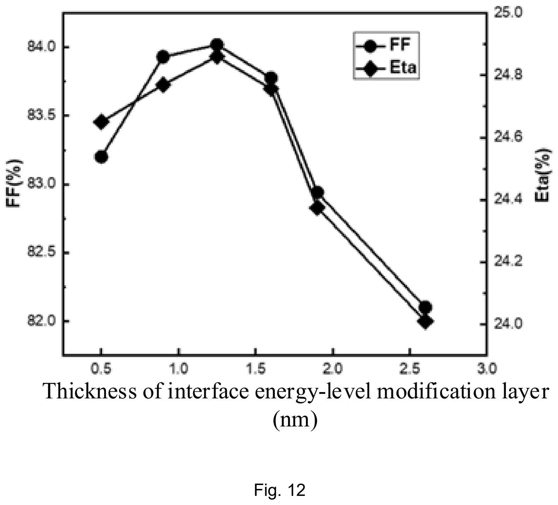

Fig. 12 shows the influence of interface energy-level modification layers with different thicknesses on the performance of the solar cell. As illustrated by Fig. 12, when the thickness of the interface energy-level modification layer is 0.50 nm, 0.91 nm, 1.25 nm, 1.59 nm, 1.92 nm and 2.60 nm respectively, the filling factors (FF) of the corresponding solar cells are 83.200%, 83.930%, 84.019%, 83.776%, 82.939% and 82.100% respectively. The photoelectric conversion efficiencies (Eta) of the corresponding solar cells are 24.65%, 24.77%, 24.86%, 24.76%, 24.38% and 24.01% respectively. According to the trend analysis of the results shown in Fig. 12, it can be concluded that the solar cell has excellent filling factor and photoelectric conversion efficiency (Eta) when the thickness of the interface energy-level modification layer is in the range of 0.7 to 1.8 nm. Considering that the diameter of silicon atoms is in the order of one tenth of angstrom, when the thickness of the interface energy-level modification layer is too thin, the distribution of various atoms is uneven, so the interface energy-level modification layer is too thin to enable the energy-level bending of the surface of silicon substrate. In addition, too thick interface energy-level modification layer has poor conductivity, which deteriorates the conductivity of the whole interface energy-level modification layer.

In another embodiment (Embodiment 5) of the present disclosure, a solar cell is prepared by steps similar to the above steps S31-S34, S35' and S36-S37. Different from the above method including steps S31-S34, S35' and S36-S37, the second p-type conductive layer is not formed in step S35', so that the formed solar cell does not have the second p-type conductive layer.

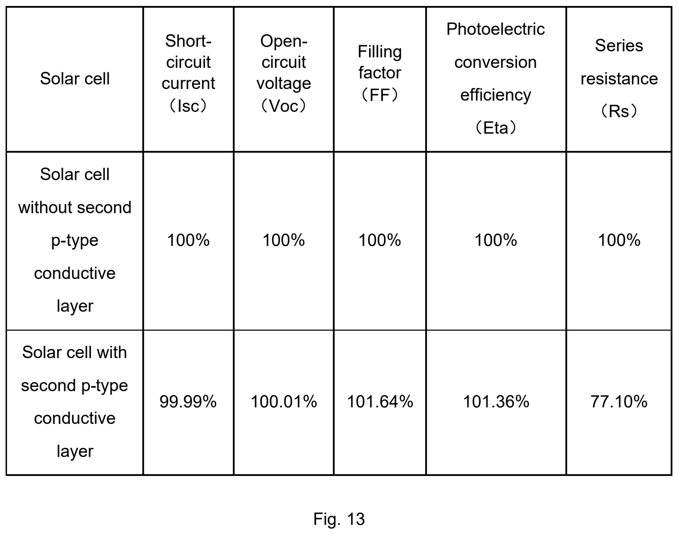

Fig. 13 shows a comparison of the performance of the solar cell with and without the second p-type conductive layer.

As can be seen from Fig. 13, when the short-circuit current, open-circuit voltage, filling factor, photoelectric conversion efficiency and series resistance of the solar cell without the second p-type conductive layer according to Example 5 are set to 100%, the short-circuit current, open-circuit voltage, filling factor, photoelectric conversion efficiency and series resistance of the solar cell according to Example 2 are 99.99%, 100.01%, 101.64%, 101.36%, and 77.10% respectively. Therefore, the second p-type conductive layer can further reduce the activation energy of the stacked semiconductor layers, reduce the contact resistance, improve the filling factor, and further improve the conversion efficiency of the solar cell.

Specifically, there may be the following reasons: first, the second p-type conductive layer can have better energy-level matching with the interface energy-level modification layer and the first p-type conductive layer, and the second p-type conductive layer can enhance the conductivity of the stacked semiconductor layers, which can increase the conductivity of the whole stacked semiconductor layers by reducing the activation of the stacked semiconductor layers; secondly, the second p-type conductive layer is an amorphous silicon layer, which is flat and uniform and has good continuous coverage, thus preventing the contact reduction caused by the overflow of highly doped boron in the inner layer; thirdly, doping amorphous silicon layer in the outer layer has better energy-level matching with ITO layer, reducing contact barrier and improving filling factor.

In the present disclosure, the formation of Si-H, C-H and B-H chemical bonds in the layer refers to the general name of this type of chemical bonds. Specifically, the Si-H chemical bonds in the layer include Si-H, Si-H2, Si-H3 and other chemical bonds. It is further pointed out that the bonding state between hydrogen atoms and silicon atoms (that is, the electron cloud distribution tendency of silicon-hydrogen groups) can include various forms, such as the formation of H0, H+ or hydrogen anti-bonds. Specifically, the C-H chemical bonds in the layer include C-H, C-H2, C-H3 and other chemical bonds; Specifically, the B-H chemical bonds in the layer include B-H, B-H2, B2-H1, B2-H2, B2-H3, B2-H4, B2-H5 and other chemical bonds.

The scope of the present disclosure is defined not by the above-described embodiments, but by the appended claims and their equivalents.

## Claims

1. A solar cell, comprising:
a silicon substrate, which is an n-type silicon substrate;
a passivation layer;
a seed layer;
an interface energy-level modification layer, which is a p-type hydrogenated doped silicon layer; and
a first p-type conductive layer;
wherein the passivation layer, the seed layer, the interface energy-level modification layer, and the first p-type conductive layer are sequentially stacked in at least a partial area of a first surface on a first side of the silicon substrate, and the passivation layer is closest to the silicon substrate,
wherein the interface energy-level modification layer comprises silicon, oxygen, carbon, hydrogen and boron,
wherein a bandgap width of the interface energy-level modification layer is in a range of 1.9 to 2.3 eV, and a thickness of the interface energy-level modification layer is in a range of 0.5 to 4 nm.

2. The solar cell according to claim 1, wherein,
the thickness of the interface energy-level modification layer is in a range of 0.7 to 1.8 nm.

3. The solar cell according to claim 1 or 2, wherein,
the interface energy-level modification layer is a hydrogenated amorphous silicon layer and is embedded with crystallized silicon, and a crystallization rate of the interface energy-level modification layer is in a range of 30 to 65%.

4. The solar cell according to any one of claims 1-3, wherein,
the interface energy-level modification layer includes Si-Si, Si-O, Si-C, Si-B, C-C, C-O, C=O, C-B and B-O chemical bonds.

5. The solar cell according to claim 4, wherein,
a total molar content of the carbon and the oxygen in the interface energy-level modification layer is in a range of 18 to 45%, and a concentration of active boron atoms in the interface energy-level modification layer is in a range of 5×10¹⁷ to 5×10¹⁹ atoms per cubic centimeter.

6. The solar cell according to claim 5, wherein,
a molar content of the carbon in the interface energy-level modification layer is in a range of 8-16%, and the carbon exists by forming Si-C, C-C, C-O, C=O, C-B and C-H chemical bonds,
molar ratios of the carbon existing through Si-C, C-C, C-O, C=O, C-B and C-H chemical bonds to all carbon are 30-54%, 30-45%, 8-14%, 1-5%, 3-7% and 3-9%, respectively.

7. The solar cell according to claim 5 or 6, wherein,
a molar content of the oxygen in the interface energy-level modification layer is in a range of 18-32%, and the oxygen exists by forming Si-O, C-O and B-O chemical bonds,
molar ratios of the oxygen existing through Si-O, C-O and B-O chemical bonds to all oxygen are 78-92%, 6-15% and 4-11%, respectively.

8. The solar cell according to any one of claims 5-7, wherein,
a molar content of the silicon in the interface energy-level modification layer is in a range of 50-65%, and the silicon exists by forming Si-Si, Si-O, Si-C, Si-B and Si-H chemical bonds,
a molar ratio of silicon existing through Si-Si, Si-B and Si-H chemical bonds to all silicon is 40-60%, a molar ratio of silicon existing through Si-O chemical bonds to all silicon is 35-45%, and a molar ratio of silicon existing through Si-C chemical bonds to all silicon is 7-12%.

9. The solar cell according to any one of claims 5-8, wherein,
a molar content of boron in the interface energy-level modification layer is in a range of 1-5%,
inactive boron atoms exist in the layer in form of B-O, B-C, B-B and B-H.

10. The solar cell according to any one of claims 5-9, wherein,
in the interface energy-level modification layer, in a direction away from the silicon substrate, a concentration of the active boron atoms increases and a crystallization rate of the interface energy-level modification layer increases.

11. The solar cell according to any one of claims 1-10, wherein,
the passivation layer is a hydrogenated amorphous silicon layer, and
in the passivation layer, a concentration of hydrogen atoms decreases in a direction away from the silicon substrate.

12. The solar cell according to any one of claims 1-11, wherein,
the first p-type conductive layer is a p-type microcrystalline silicon layer,
a crystallization rate of the first p-type conductive layer is in a range of 30-70%,
in the first p-type conductive layer, a crystallization rate increases in a direction away from the silicon substrate.

13. The solar cell according to any one of claims 1-12, wherein,
the passivation layer is a hydrogenated amorphous silicon layer,
the first p-type conductive layer is a p-type microcrystalline silicon layer,
a thickness of the passivation layer is in a range of 5-8 nm,
a thickness of the seed layer is smaller than 1 nm,
a thickness of the first p-type conductive layer is in a range of 20-38 nm.

14. The solar cell according to any one of claims 1-13, further comprises:
a second p-type conductive layer, disposed on the first p-type conductive layer and further away from the silicon substrate than the first p-type conductive layer.

15. The solar cell according to claim 14, wherein,
the second p-type conductive layer is a boron-doped amorphous silicon layer,
wherein a concentration of active boron atoms in the second p-type conductive layer is in a range of 2×10¹⁸-1×10¹⁹ atoms per cubic centimeter,
a thickness of the second p-type conductive layer is in a range of 0.5-3 nm.

16. The solar cell according to any one of claims 1-15, wherein,
the first side is a backlight side of the solar cell.

17. The solar cell according to any one of claims 1-16, further comprising:
a second passivation layer; and
an n-type conductive layer,
wherein the second passivation layer and the n-type conductive layer are sequentially stacked on a second surface on a second side of the silicon substrate, the second side is opposite to the first side, and the second passivation layer is closest to the silicon substrate.

18. The solar cell according to any one of claims 1-17, further comprising:
a second passivation layer; and
an n-type conductive layer,
wherein the passivation layer, the seed layer, the interface energy-level modification layer, the first p-type conductive layer and the second p-type conductive layer are sequentially stacked in a p area on the first surface on the first side of the silicon substrate,
the second passivation layer and the n-type conductive layer are sequentially stacked in an n area different from the p area on the first surface of the silicon substrate.

19. A manufacturing method of a solar cell, used for manufacturing the solar cell according to any one of claims 1-18, the method comprising:
providing a silicon substrate; and
sequentially stacking a passivation layer, a seed layer, an interface energy-level modification layer, and a first p-type conductive layer in at least a partial area of the first surface on the first side of the silicon substrate,
wherein a bandgap width of the interface energy-level modification layer is in a range of 1.9 to 2.3 eV, and a thickness of the interface energy-level modification layer is in a range of 0.5 to 4 nm.

20. The manufacturing method according to claim 19, wherein:
the interface energy-level modification layer is formed by using reaction gas under the conditions that a pressure of reaction cavity is in a range of 2.5-3.5 Torr and a radio frequency power density is in a range of 260-340 mW/cm²,
the silicon of the interface energy-level modification layer is from one or more selected from a group consisting of SiH₄ and Si2H₆,
the boron of the interface energy-level modification layer is from one or more selected from a group consisting of TMB, B₂H₆ and BF₃,
the hydrogen of the interface energy-level modification layer is from one or more selected from a group consisting of H₂, SiH₄, B₂H₆ and TMB,
the oxygen of the interface energy-level modification layer is from one or more selected from a group consisting of N₂O, O₂, CO and CO₂, and
the carbon of the interface energy-level modification layer is from one or more selected from a group consisting of CO₂, CO, CH₄, C₂H₆, C₃H₁₀ and C₂H₄.
